# EUROPEAN PATENT APPLICATION

(11) **EP 4 468 352 A1**
(43) Date of publication of application: **27.11.2024**
(21) Application number: 24150156.8
(22) Date of filing: 03.01.2024
(51) Int. Cl.: H01L 27/02, H10B 61/00, H10N 50/01, H10N 50/10

(54) **SEMICONDUCTOR DEVICE**

(30) Priority: 26.05.2023 KR 20230068435
(71) Applicant: Samsung Electronics Co., Ltd., Suwon-si, Gyeonggi-do 16677 (KR)
(72) Inventor: LEE, Kilho, 16677 Suwon-si (KR); PARK, Junho, 16677 Suwon-si (KR); BAE, Byoungjae, 16677 Suwon-si (KR)
(74) Representative: Marks & Clerk LLP

(57) **Abstract**

A semiconductor device includes data storage patterns (DS) provided on a substrate (100) and spaced apart from each other in first (D1) and second directions (D2) parallel to a top surface of the substrate, first cell conductive lines (192) provided on the data storage patterns (DS), extended in the first direction (D1), and spaced apart from each other in the second direction (D2), each of the first cell conductive lines (192) being connected to corresponding ones of the data storage patterns (DS), which are spaced apart from each other in the first direction (D1), and cell via contacts (200) spaced apart from each other in the first direction (D1), between the first cell conductive lines (192). Each of the cell via contacts (200) between the first cell conductive lines (192) extends in the second direction (D2) and is connected to dummy data storage patterns (DS_d) of the data storage patterns, which are spaced apart from each other in the second direction (D2).

## Description

### BACKGROUND OF THE INVENTION

The present disclosure relates to a semiconductor device and a method of fabricating the same, and in particular, to a semiconductor device including a magnetic tunnel junction and a method of fabricating the same.

As the demand for electronic devices with increased speed and/or reduced power consumption increases, the demand for semiconductor memory devices with faster operating speeds and/or lower operating voltages is increasing. A magnetic memory device has been proposed to satisfy such a demand. For example, the magnetic memory device can provide technical advantages, such as high speed and/or non-volatility, and thus, the magnetic memory device is emerging as a next-generation memory device.

In general, the magnetic memory device includes a magnetic tunnel junction (MTJ) pattern. The MTJ pattern includes two magnetic layers and an insulating layer interposed therebetween. Resistance of the MTJ pattern may vary depending on magnetization directions of the magnetic layers. For example, the electric resistance of the MTJ pattern is higher when magnetization directions of the magnetic layers are anti-parallel to each other than when they are parallel to each other. Such a difference in electric resistance can be used for data storing/reading operations of the magnetic memory device.

An embedded structure of the magnetic memory device, in which the MTJ pattern is disposed between metal lines, is being developed to meet various demands for the electronics industry.

### SUMMARY

The present disclosure provides a method of reducing a process defect in a process of fabricating a semiconductor device and a semiconductor device fabricated thereby. Also provided is a semiconductor device with improved electrical characteristics and a method of fabricating the same.

In general, innovative aspects of the subject matter described in this specification can be embodied in a semiconductor device including: data storage patterns provided on a substrate and spaced apart from each other in a first direction and a second direction, which are parallel to a top surface of the substrate and are non-parallel to each other, first cell conductive lines provided on the data storage patterns, extended in the first direction, and spaced apart from each other in the second direction, each of the first cell conductive lines being connected to corresponding ones of the data storage patterns spaced apart from each other in the first direction, and cell via contacts spaced apart from each other in the first direction, between the first cell conductive lines. Each of the cell via contacts between the first cell conductive lines may be extended in the second direction and may be connected to dummy data storage patterns, which are ones of the data storage patterns spaced apart from each other in the second direction.

Another general aspect can be embodied in a semiconductor device that includes: first cell conductive lines provided on a substrate, extended in a first direction, and spaced apart from each other in a second direction, the first and second directions being parallel to a top surface of the substrate and crossing each other, a cell via contact provided between the first cell conductive lines, extended in the second direction, and spaced apart from the first cell conductive lines, data storage patterns connected to bottom surfaces of the first cell conductive lines, respectively, and spaced apart from each other in the second direction, and dummy data storage patterns connected to a bottom surface of the cell via contact and spaced apart from each other in the second direction. The cell via contact may include a vertical portion provided between the dummy data storage patterns and extended in a third direction perpendicular to the top surface of the substrate, and a horizontal portion provided on the vertical portion, extended in the second direction, and connected to the dummy data storage patterns.

At least some of the above and other features of the invention are set out in the claims.

### BRIEF DESCRIPTION OF THE DRAWINGS

FIG. 1 is a circuit diagram illustrating an examples of a unit memory cell of a semiconductor device.
FIG. 2 is a plan view illustrating an example of a semiconductor device.
FIG. 3 is a sectional view, which is taken along a line I-I' of FIG 2.
FIGS. 4A and 4B are sectional views, each of which illustrates an example of a magnetic tunnel junction pattern of a semiconductor device.
FIGS. 5 to 8 are sectional views along the line I-I' of FIG. 2 and illustrate an example of a method of fabricating a semiconductor device.
FIG. 9 is a sectional view along the line I-I' of FIG. 2 and illustrates the semiconductor device of FIG. 2.

### DETAILED DESCRIPTION

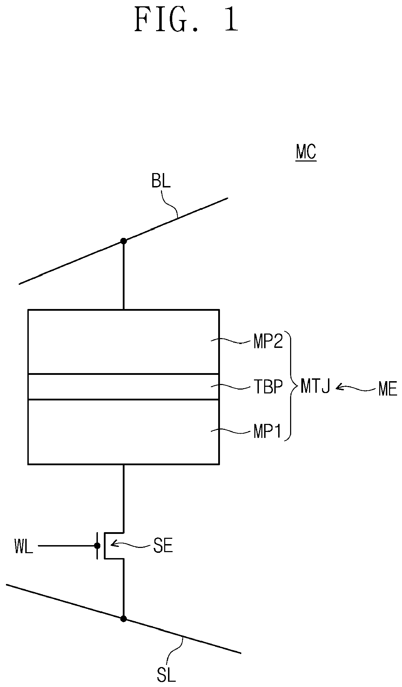

FIG. 1 is a circuit diagram illustrating an examples of a unit memory cell of a semiconductor device.

Referring to FIG. 1, a unit memory cell MC includes a memory element ME and a selection element SE. The memory element ME and the selection element SE may be electrically connected to each other in series. The memory element ME may be provided between and connected to a bit line BL and the selection element SE. The selection element SE may be provided between and connected to the memory element ME and a source line SL and may be controlled by a word line WL. The selection element SE may include, for example, a bipolar transistor or a metal-oxide-semiconductor (MOS) field effect transistor.

The memory element ME may include a magnetic tunnel junction pattern MTJ including magnetic patterns MP1 and MP2, which are spaced apart from each other, and a tunnel barrier pattern TBP, which is interposed between the magnetic patterns MP1 and MP2. One of the magnetic patterns MP1 and MP2 may have a fixed magnetization direction, regardless of the presence of an external magnetic field generated under a typical user condition, and thus, it may serve as a reference magnetic pattern of the magnetic tunnel junction pattern MTJ. The other of the magnetic patterns MP1 and MP2 may have a magnetization direction, which can be changed to one of two stable magnetization directions by an external magnetic field, and thus, it may serve as a free magnetic pattern of the magnetic tunnel junction pattern MTJ. The electric resistance of the magnetic tunnel junction pattern MTJ may be much greater when magnetization directions of the reference and free magnetic patterns are antiparallel than when they are parallel. In other words, the electric resistance of the magnetic tunnel junction pattern MTJ may be controlled by adjusting the magnetization direction of the free magnetic pattern. Thus, a difference in electric resistance of the magnetic tunnel junction pattern MTJ, which is caused by a difference in magnetization direction between the reference and free magnetic patterns, may be used as a mechanism for storing data in the memory element ME or the unit memory cell MC.

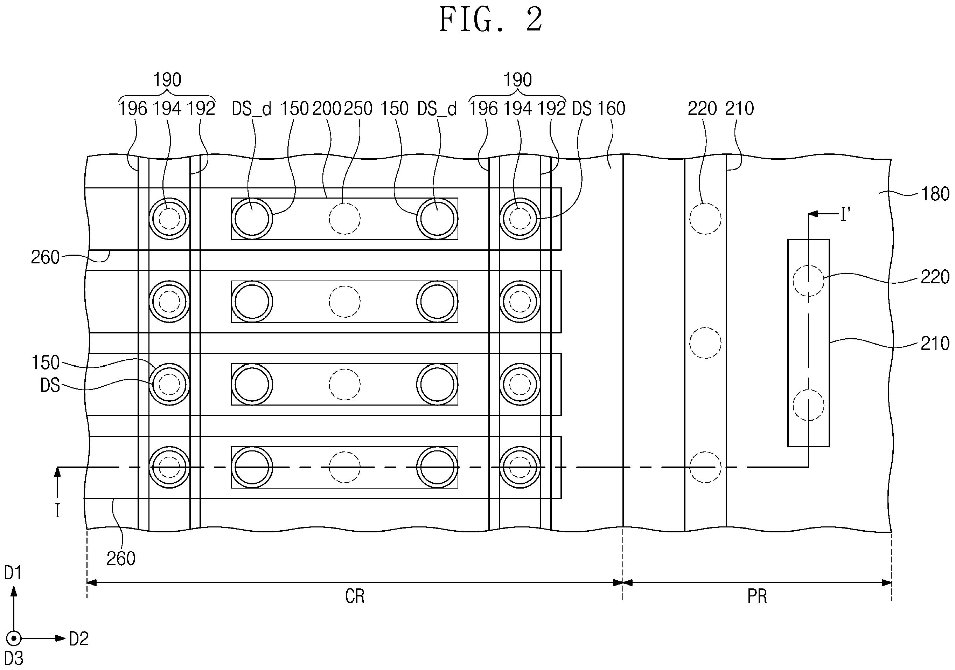

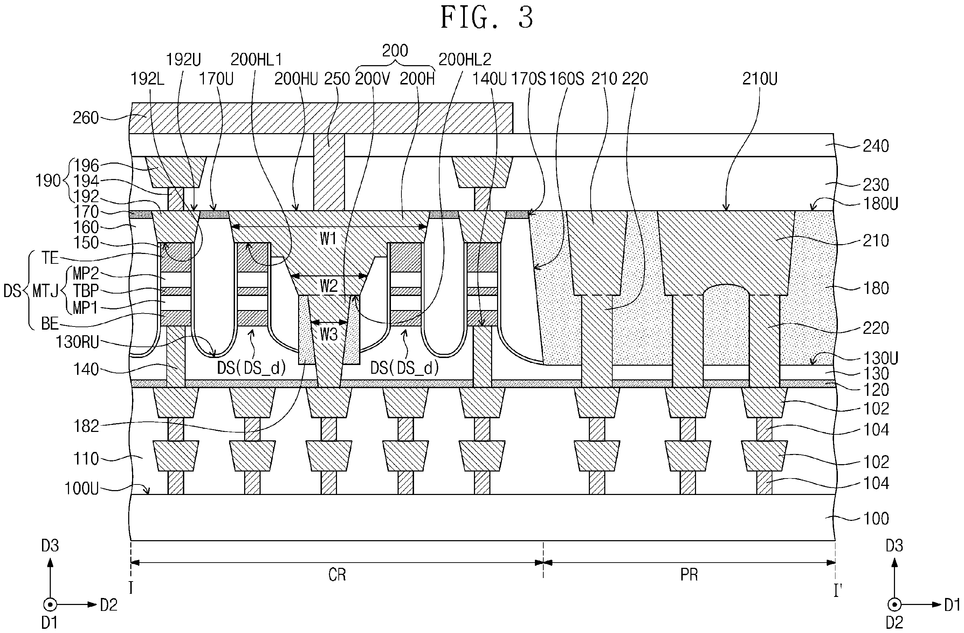

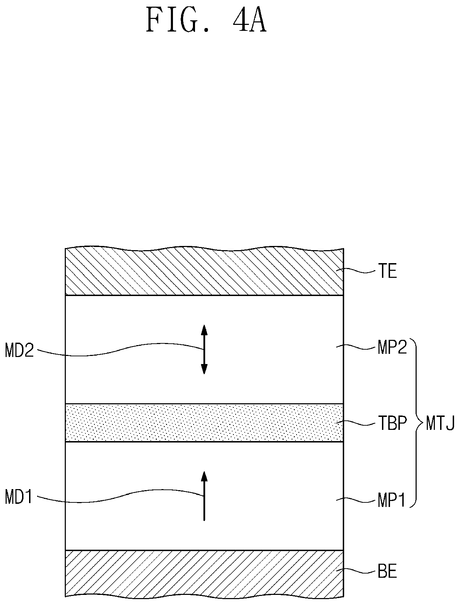

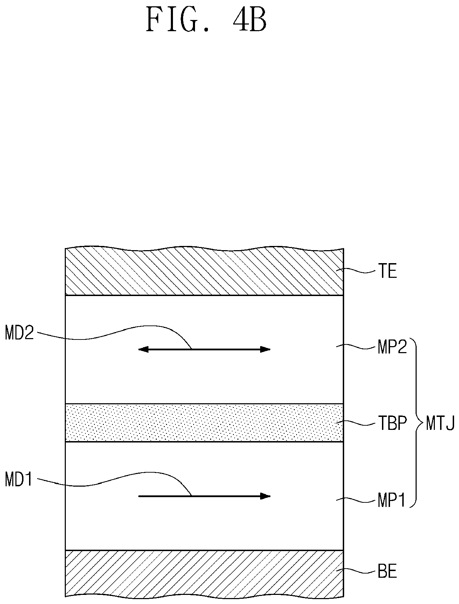

FIG. 2 is a plan view illustrating an example of a semiconductor device. FIG. 3 is a sectional view, which is taken along a line I-I' of FIG. 2 to illustrate the semiconductor device. FIGS. 4A and 4B are sectional views, each of which illustrates a magnetic tunnel junction pattern of a semiconductor device.

Referring to FIGS. 2 and 3, a substrate 100 including a cell region CR and a peripheral region PR may be provided. The substrate 100 may be a semiconductor substrate, which is formed of or includes at least one of silicon (Si), silicon germanium (SiGe), germanium (Ge), or gallium arsenide (GaAs), or may be a silicon-on-insulator (SOI) wafer. The cell region CR may be a region of the substrate 100, on which the memory cells MC of FIG. 1 are located, and the peripheral region PR may be another region of the substrate 100, on which peripheral circuits for driving the memory cells MC are located.

An interconnection structure (e.g., 102 and/or 104) may be disposed on the substrate 100. The interconnection structure (e.g., 102 and/or 104) may be disposed on the cell region CR and the peripheral region PR of the substrate 100. The interconnection structure (e.g., 102 and/or 104) includes interconnection lines 102, which are vertically spaced apart from the substrate 100, and interconnection contacts 104, which are connected to the interconnection lines 102. The interconnection lines 102 may be spaced apart from a top surface 100U of the substrate 100 in a direction perpendicular to the top surface 100U of the substrate 100. The interconnection contacts 104 may be disposed between the substrate 100 and the interconnection lines 102. Each of the interconnection lines 102 may be electrically connected to the substrate 100 through a corresponding one of the interconnection contacts 104. The interconnection lines 102 and the interconnection contacts 104 may be formed of or include at least one metallic material (e.g., copper).

The selection elements SE of FIG. 1 may be disposed on the cell region CR of the substrate 100, and peripheral transistors constituting the peripheral circuits may be disposed on the peripheral region PR of the substrate 100. In some implementations, the selection elements and the peripheral transistors may be field effect transistors. Each of the interconnection lines 102 may be electrically connected to one terminal (e.g., a source, drain, or gate terminal) of a corresponding one of the selection elements or the peripheral transistors through a corresponding one of the interconnection contacts 104.

An interconnection insulating layer 110 may be disposed on the substrate 100 to cover the interconnection structure, e.g., interconnection lines 102 and interconnection contacts 104. The interconnection insulating layer 110 may be disposed on the cell region CR of the substrate 100 and may be extended to the peripheral region PR of the substrate 100. The interconnection insulating layer 110 may be provided to expose top surfaces of the uppermost ones of the interconnection lines 102. As an example, a top surface of the interconnection insulating layer 110 may be substantially coplanar with the top surfaces of the uppermost interconnection lines 102. The interconnection insulating layer 110 may be formed of or include at least one of silicon oxide, silicon nitride, and/or silicon oxynitride.

A first lower insulating layer 120 may be disposed on the interconnection insulating layer 110 and may cover the exposed top surfaces of the uppermost ones of the interconnection lines 102. The first lower insulating layer 120 may be disposed on the interconnection insulating layer 110 in the cell region CR and may be extended to a region on the interconnection insulating layer 110 in the peripheral region PR. The first lower insulating layer 120 may be formed of or include at least one of silicon oxide, silicon nitride, and/or silicon oxynitride.

A second lower insulating layer 130 may be disposed on the first lower insulating layer 120. The second lower insulating layer 130 may be disposed on the first lower insulating layer 120 in the cell region CR and may be extended to cover the first lower insulating layer 120 in the peripheral region PR. In the cell region CR and the peripheral region PR, the first lower insulating layer 120 may be interposed between the interconnection insulating layer 110 and the second lower insulating layer 130. The second lower insulating layer 130 may be formed of or include at least one of silicon oxide, silicon nitride, and/or silicon oxynitride. The first lower insulating layer 120 and the second lower insulating layer 130 may be referred to as a lower insulating layer.

Data storage patterns DS may be disposed on the second lower insulating layer 130 in the cell region CR. The data storage patterns DS may be spaced apart from each other in a first direction D1 and a second direction D2, which are parallel to the top surface 100U of the substrate 100 and are non-parallel to each other. The second lower insulating layer 130 in the cell region CR may have a top surface 130RU, which is formed between the data storage patterns DS and is recessed toward the substrate 100. A top surface 130U of the second lower insulating layer 130 in the peripheral region PR may be located at a height that is lower than the recessed top surface 130RU of the second lower insulating layer 130 in the cell region CR. In the present specification, the term 'height' is used to represent a distance from the top surface 100U of the substrate 100, which is measured in a third direction D3 perpendicular to the top surface 100U of the substrate 100.

Bottom electrode contacts 140 may be disposed in the second lower insulating layer 130 and on the cell region CR and may be spaced apart from each other in the first direction D1 and the second direction D2. The bottom electrode contacts 140 may be disposed below and electrically connected to respective ones of the data storage patterns DS. The data storage patterns DS may include dummy data storage patterns DS_d, which are disconnected from the bottom electrode contacts 140. Each of the bottom electrode contacts 140 may penetrate the first and second lower insulating layers 120 and 130 in the cell region CR and may be connected to a corresponding one of the uppermost interconnection lines 102. Each of the corresponding data storage patterns DS may be electrically connected to a terminal (e.g., a drain terminal) of a corresponding one of the selection elements through a corresponding one of the bottom electrode contacts 140 and a corresponding one of the uppermost interconnection lines 102.

Top surfaces 140U of the bottom electrode contacts 140 may be located at a height higher than the recessed top surface 130RU of the second lower insulating layer 130 in the cell region CR. The bottom electrode contacts 140 may be formed of or include at least one of doped semiconductor materials (e.g., doped silicon), metallic materials (e.g., tungsten, titanium, and/or tantalum), metal-semiconductor compounds (e.g., metal silicide), and conductive metal nitrides (e.g., titanium nitride, tantalum nitride, and/or tungsten nitride).

Each of the data storage patterns DS may include a bottom electrode BE, a magnetic tunnel junction pattern MTJ, and a top electrode TE, which are sequentially stacked on the second lower insulating layer 130 in the third direction D3. The magnetic tunnel junction pattern MTJ may be disposed between the bottom electrode BE and the top electrode TE. Each of the bottom electrode contacts 140 may be connected to the bottom electrode BE of each of the corresponding data storage patterns DS. The magnetic tunnel junction pattern MTJ may include a first magnetic pattern MP1, a second magnetic pattern MP2, and a tunnel barrier pattern TBP therebetween. The first magnetic pattern MP1 may be disposed between the bottom electrode BE and the tunnel barrier pattern TBP, and the second magnetic pattern MP2 may be disposed between the top electrode TE and the tunnel barrier pattern TBP. The bottom electrode BE may be formed of or include at least one of, for example, conductive metal nitrides (e.g., titanium nitride or tantalum nitride). The top electrode TE may be formed of or include at least one metallic material (e.g., Ta, W, Ru, and Ir) or conductive metal nitrides (e.g., TiN).

Referring to FIGS. 4A and 4B, the first magnetic pattern MP1 may be a reference layer whose magnetization direction MD1 is fixed to a specific direction, and the second magnetic pattern MP2 may be a free layer whose magnetization direction MD2 can be changed to be parallel or antiparallel to the magnetization direction MD1 of the first magnetic pattern MP 1. FIGS. 4A and 4B illustrate an example, in which the second magnetic pattern MP2 is used as the free layer, but the present disclosure is not limited to this example. In some implementations, unlike the structure shown in FIGS. 4A and 4B, the first magnetic pattern MP1 may be the free layer, and the second magnetic pattern MP2 may be the reference layer.

Referring to FIG. 4A, the magnetization directions MD1 and MD2 of the first and second magnetic patterns MP1 and MP2 may be perpendicular to an interface between the tunnel barrier pattern TBP and the second magnetic pattern MP2. In this case, each of the first and second magnetic patterns MP1 and MP2 may be formed of or include at least one of intrinsic and extrinsic perpendicular magnetic materials. The intrinsic perpendicular magnetic material may include a material exhibiting a perpendicular magnetization property, even when there is no external cause. The intrinsic perpendicular magnetic material may include at least one of i) perpendicular magnetic materials (e.g., CoFeTb, CoFeGd, and CoFeDy), ii) perpendicular magnetic materials with L1₀ structure, iii) CoPt-based materials with hexagonal-close-packed structure, or iv) perpendicular magnetic structures. The perpendicular magnetic material with the L1₀ structure may include at least one of L1₀ FePt, L1₀ FePd, L1₀ CoPd, or L1₀ CoPt. The perpendicular magnetic structures may include magnetic and non-magnetic layers that are alternatingly and repeatedly stacked. As an example, the perpendicular magnetic structure may include at least one of (Co/Pt)ₙ, (CoFe/Pt)ₙ, (CoFe/Pd)ₙ, (Co/Pd)ₙ, (Co/Ni)ₙ, (CoNi/Pt)ₙ, (CoCr/Pt)ₙ, or (CoCr/Pd)ₙ, where "n" is a natural number equal to or greater than 2. The extrinsic perpendicular magnetic material may include a material, which exhibits an intrinsic in-plane magnetization property when there is no external cause but exhibits a perpendicular magnetization property by an external cause. For example, due to a magnetic anisotropy, which results from interfacial characteristics between the first or second magnetic pattern MP1 or MP2 and the tunnel barrier pattern TBP, the extrinsic perpendicular magnetic material may have the perpendicular magnetization property. The extrinsic perpendicular magnetic material may be formed of or include, for example, CoFeB.

Referring to FIG. 4B, the magnetization directions MD1 and MD2 of the first and second magnetic patterns MP1 and MP2 may be parallel to the interface between the tunnel barrier pattern TBP and the second magnetic pattern MP2. In this case, each of the first and second magnetic patterns MP1 and MP2 may be formed of or include at least one of ferromagnetic materials. The first magnetic pattern MP1 may further include an antiferromagnetic material, which is provided in the first magnetic pattern MP1 and is used to fix a magnetization direction of the ferromagnetic material.

Each of the first and second magnetic patterns MP1 and MP2 may be formed of or include at least one of Co-containing Heusler alloys. The tunnel barrier pattern TBP may include at least one of, for example, magnesium oxide, titanium oxide, aluminum oxide, magnesium-zinc oxide, or magnesium-boron oxide.

Referring back to FIGS. 2 and 3, a capping insulating layer 150 may be disposed on the second lower insulating layer 130 in the cell region CR. The capping insulating layer 150 may conformally cover the side surface of each of the data storage patterns DS and the recessed top surface 130RU of the second lower insulating layer 130 in the cell region CR. The capping insulating layer 150 may enclose the side surface of each of the data storage patterns DS, when viewed in a plan view. The capping insulating layer 150 may conformally cover the side surfaces of the bottom electrode BE, the magnetic tunnel junction pattern MTJ, and the top electrode TE. The capping insulating layer 150 may enclose the side surfaces of the bottom electrode BE, the magnetic tunnel junction pattern MTJ, and the top electrode TE, when viewed in a plan view. The capping insulating layer 150 may be formed of or include at least one nitride material (e.g., silicon nitride).

A cell insulating layer 160 may be disposed on the second lower insulating layer 130 in the cell region CR and may cover the data storage patterns DS. The cell insulating layer 160 may fill a space between the data storage patterns DS. The capping insulating layer 150 may be interposed between the side surface of each of the data storage patterns DS and the cell insulating layer 160 and may be extended to a region between the recessed top surface 130RU of the second lower insulating layer 130 and the cell insulating layer 160. The cell insulating layer 160 may be formed of or include at least one of silicon oxide, silicon nitride, and/or silicon oxynitride. As an example, the cell insulating layer 160 may be formed of or include at least one oxide material (e.g., tetra-ethyl ortho-silicate (TEOS)).

An upper insulating layer 170 may be disposed on the cell region CR and on the cell insulating layer 160. The upper insulating layer 170 may include a material different from the cell insulating layer 160. For example, the upper insulating layer 170 may be formed of or include a type of silicon nitride (e.g., SiCN).

A peripheral insulating layer 180 may be disposed on the second lower insulating layer 130 in the peripheral region PR. The top surface 130U of the second lower insulating layer 130 in the peripheral region PR may be located at a height lower than the recessed top surface 130RU of the second lower insulating layer 130 in the cell region CR, and the peripheral insulating layer 180 may be in contact with the top surface 130U of the second lower insulating layer 130 in the peripheral region PR. The peripheral insulating layer 180 may be in contact with a side surface 160S of the cell insulating layer 160 and a side surface 170S of the upper insulating layer 170. A top surface 180U of the peripheral insulating layer 180 may be located at the same height as a top surface 170U of the upper insulating layer 170. The top surface 180U of the peripheral insulating layer 180 may be coplanar with the top surface 170U of the upper insulating layer 170.

The peripheral insulating layer 180 may include a material different from the cell insulating layer 160. The peripheral insulating layer 180 may be formed of or include an insulating material having a dielectric constant (k) lower than the cell insulating layer 160. The peripheral insulating layer 180 may include a material different from the upper insulating layer 170, and in some implementations, it may be formed of or include an insulating material having a dielectric constant (k) lower than the upper insulating layer 170. The peripheral insulating layer 180 may be formed of or include at least one of silicon oxide, silicon nitride, and/or silicon oxynitride. As an example, the peripheral insulating layer 180 may include an insulating material (e.g., porous SiOC) whose dielectric constant (k) is lower than about 2.5 or 2.0.

First cell conductive lines 192 may be disposed on the cell region CR. The first cell conductive lines 192 may be extended in the first direction D1 and may be spaced apart from each other in the second direction D2. Each of the first cell conductive lines 192 may be a line-shaped pattern, which is extended in the first direction D1. Each of the first cell conductive lines 192 may be electrically connected to corresponding ones of the data storage patterns DS, which are spaced apart from each other in the first direction D1. The data storage patterns DS, which are spaced apart from each other in the second direction D2, may be electrically connected to the first cell conductive lines 192, respectively. In one example, first cell conductive lines provided on the data storage patterns.

Each of the first cell conductive lines 192 may be provided to penetrate the upper insulating layer 170 and an upper portion of the cell insulating layer 160 and may be connected to the corresponding data storage patterns DS, which are spaced apart from each other in the first direction D1. A bottom surface 192L of each of the first cell conductive lines 192 may be in contact with the corresponding data storage patterns DS, which are spaced apart from each other in the first direction D1, and may be in contact with the top electrode TE of each of the corresponding data storage patterns DS, which are spaced apart from each other in the first direction D1. The first cell conductive lines 192 may include a conductive material and may be formed of or include, for example, a metallic material (e.g., copper).

Cell via contacts 200 may be disposed on the cell region CR and between the first cell conductive lines 192. The cell via contacts 200 between the first cell conductive lines 192 may be spaced apart from each other in the first direction D1 and may be extended in the second direction D2. Each of the cell via contacts 200 may be a bar-shaped pattern, which is elongated in the second direction D2 when viewed in a plan view. The cell via contacts 200 may be spaced apart from the first cell conductive lines 192 in a horizontal direction (e.g., the second direction D2).

Each of the cell via contacts 200 between the first cell conductive lines 192 may be extended in the second direction D2 and may be connected to dummy data storage patterns DS_d of the data storage patterns DS, which are spaced apart from each other in the second direction D2. The data storage patterns DS, which are respectively connected to the first cell conductive lines 192, may be spaced apart from each other in the second direction D2 with the dummy data storage patterns DS_d interposed therebetween.

Each of the cell via contacts 200 may include a vertical portion 200V, which is placed between the dummy data storage patterns DS_d and is extended in the third direction D3, and a horizontal portion 200H, which is extended from the vertical portion 200V in the second direction D2 and is connected to the dummy data storage patterns DS_d. The vertical portion 200V may be spaced apart from the dummy data storage patterns DS_d in a horizontal direction (e.g., the second direction D2). The horizontal portion 200H may have end portions, which are opposite to each other in the second direction D2, and the dummy data storage patterns DS_d may be respectively connected to the end portions of the horizontal portion 200H. The magnetic tunnel junction patterns MTJ of the dummy data storage patterns DS_d are attached to the opposite end portions of the horizontal portion 200H of the cell via contact 200. The horizontal portion 200H may be spaced apart from the first cell conductive lines 192 in a horizontal direction (e.g., the second direction D2).

Each of the cell via contacts 200 may have a width in the second direction D2. Widths W1 and W2 of the horizontal portion 200H in the second direction D2 may increase as a distance from the vertical portion 200V in the third direction D3 increases. In some implementations, a width W1 of an upper portion of the horizontal portion 200H may be larger than a width W2 of a lower portion of the horizontal portion 200H. The width W2 of the lower portion of the horizontal portion 200H may be larger than the largest width W3 of the vertical portion 200V.

At the end portions of the horizontal portion 200H, a bottom surface 200HL1 of the horizontal portion 200H may be in contact with the dummy data storage patterns DS_d. The bottom surface 200HL1 of the horizontal portion 200H may be in contact with the top electrode TE of each of the dummy data storage patterns DS_d. The vertical portion 200V may be connected to the bottommost surface 200HL2 of the horizontal portion 200H and may be extended from the bottommost surface 200HL2 of the horizontal portion 200H toward the substrate 100. The bottommost surface 200HL2 of the horizontal portion 200H may be located at a height that is lower than the bottom surface 200HL1 of the horizontal portion 200H and is lower than the bottom surfaces 192L of the first cell conductive lines 192.

A top surface 200HU of the horizontal portion 200H may be located at the same height as top surfaces 192U of the first cell conductive lines 192 and the top surface 170U of the upper insulating layer 170. The top surface 200HU of the horizontal portion 200H may be coplanar with the top surfaces 192U of the first cell conductive lines 192 and the top surface 170U of the upper insulating layer 170. The top surface 200HU of the horizontal portion 200H may be referred to as a top surface of each of the cell via contacts 200.

The vertical portion 200V of each of the cell via contacts 200 may penetrate the first and second lower insulating layers 120 and 130 in the cell region CR and may be connected to a corresponding one of the uppermost interconnection lines 102. Each of the cell via contacts 200 may be electrically connected to a terminal (e.g., a gate terminal) of a corresponding one of the selection elements through the corresponding uppermost one of the interconnection lines 102. The cell via contacts 200 may be formed of or include the same material as the first cell conductive lines 192. The cell via contacts 200 may include a conductive material and may be formed of or include, for example, a metallic material (e.g., copper).

In some implementations, a cell insulating pattern 182 may be disposed on the cell region CR and between the dummy data storage patterns DS_d. The cell insulating pattern 182 between the dummy data storage patterns DS_d may penetrate the cell insulating layer 160 and the capping insulating layer 150 and may be extended into the second lower insulating layer 130. The cell insulating pattern 182 may be formed of or include the same material as the peripheral insulating layer 180. The cell insulating pattern 182 may include an insulating material having a dielectric constant (k) lower than the cell insulating layer 160. The cell insulating pattern 182 may be formed of or include at least one of silicon oxide, silicon nitride, and/or silicon oxynitride. As an example, the cell insulating pattern 182 may include an insulating material (e.g., porous SiOC) whose dielectric constant (k) is lower than about 2.5 or 2.0.

Each of the cell via contacts 200 may be provided to penetrate the upper insulating layer 170, the cell insulating layer 160, the cell insulating pattern 182, the second lower insulating layer 130, and the first lower insulating layer 120. The horizontal portion 200H of each of the cell via contacts 200 may penetrate the upper insulating layer 170, an upper portion of the cell insulating layer 160, and an upper portion of the cell insulating pattern 182. The vertical portion 200V of each of the cell via contacts 200 may be disposed in the cell insulating pattern 182. The vertical portion 200V of each of the cell via contacts 200 may penetrate a lower portion of the cell insulating pattern 182, the second lower insulating layer 130, and the first lower insulating layer 120 and may be connected to a corresponding one of the uppermost one of the interconnection lines 102. In an example, the vertical portion of each of the cell via contacts is connected to the corresponding uppermost conductive line of the interconnection structure.

Peripheral conductive lines 210 may be disposed on the second lower insulating layer 130 in the peripheral region PR and in the peripheral insulating layer 180. The peripheral insulating layer 180 may cover the peripheral conductive lines 210. Top surfaces 210U of the peripheral conductive lines 210 may not be covered with the peripheral insulating layer 180 and may be exposed to the outside of the peripheral insulating layer 180. The top surfaces 210U of the peripheral conductive lines 210 may be substantially coplanar with the top surface 180U of the peripheral insulating layer 180. The top surfaces 210U of the peripheral conductive lines 210 may be located at the same height as the top surface 180U of the peripheral insulating layer 180. The top surfaces 210U of the peripheral conductive lines 210 may be located at the same height as the top surfaces 192U of the first cell conductive lines 192, the top surfaces 200HU of the cell via contacts 200, and the top surface 170U of the upper insulating layer 170. The top surfaces 210U of the peripheral conductive lines 210 may be coplanar with the top surfaces 192U of the first cell conductive lines 192, the top surfaces 200HU of the cell via contacts 200, and the top surface 170U of the upper insulating layer 170.

Peripheral conductive contacts 220 may be disposed on the peripheral region PR and under the peripheral conductive lines 210. The peripheral conductive contacts 220 may be electrically connected to the peripheral conductive lines 210. Each of the peripheral conductive contacts 220 may be in contact with a corresponding one of the peripheral conductive lines 210 without any interface therebetween. The peripheral conductive contacts 220 and the corresponding peripheral conductive line 210 may be connected to each other to form a single object. Each of the peripheral conductive contacts 220 may be provided to penetrate a lower portion of the peripheral insulating layer 180. Each of the peripheral conductive contacts 220 may penetrate the second lower insulating layer 130 and the first lower insulating layer 120 in the peripheral region PR and may be electrically connected to a corresponding one of the uppermost interconnection lines 102. Each of the peripheral conductive lines 210 may be electrically connected to a terminal (e.g., a source, drain, or gate terminal) of a corresponding one of the peripheral transistors through the peripheral conductive contacts 220 thereunder and the uppermost ones of the interconnection lines 102.

The peripheral conductive lines 210 and the peripheral conductive contacts 220 may include a conductive material and may be formed of or include, for example, a metallic material (e.g., copper). The first cell conductive lines 192, the cell via contacts 200, the peripheral conductive lines 210, and the peripheral conductive contacts 220 may be formed of or include the same material.

A first interlayer insulating layer 230 may be disposed on the cell region CR and the peripheral region PR and may cover the top surface 170U of the upper insulating layer 170, the top surfaces 192U of the first cell conductive lines 192, the top surfaces 200HU of the cell via contacts 200, the top surface 180U of the peripheral insulating layer 180, and the top surfaces 210U of the peripheral conductive lines 210. The first interlayer insulating layer 230 may be formed of or include at least one of silicon oxide, silicon nitride, and/or silicon oxynitride.

Second cell conductive lines 196 may be disposed in the first interlayer insulating layer 230 on the cell region CR. The second cell conductive lines 196 may be extended in the first direction D1 and may be spaced apart from each other in the second direction D2. The second cell conductive lines 196 may be overlapped with the first cell conductive lines 192, respectively, in a vertical direction (e.g., the third direction D3). First conductive contacts 194 may be disposed in the first interlayer insulating layer 230 on the cell region CR and may be disposed between the first cell conductive lines 192 and the second cell conductive lines 196. Each of the first cell conductive lines 192 may be electrically connected to a corresponding one of the second cell conductive lines 196 through corresponding ones of the first conductive contacts 194. The first cell conductive line 192, the first conductive contacts 194, and the second cell conductive line 196 may constitute the bit line 190, which corresponds to the bit line BL of FIG. 1. With reference to FIG. 3, the cell via contact 200 can have a bottom surface at a height lower than a height of a bottom surface of the bit line 190. For example, the bottom surface of the first cell conductive lines 192 (at least part of the bit line 190) is higher than the bottom surface of the cell via contact 200. The first conductive contacts 194 and the second cell conductive lines 196 may include a conductive material and may be formed of or include, for example, a metallic material (e.g., copper).

A second interlayer insulating layer 240 may be disposed on the cell region CR and the peripheral region PR to cover top surfaces of the second cell conductive lines 196. In some implementations, the second interlayer insulating layer 240 may be formed of or include at least one of silicon oxide, silicon nitride, silicon oxynitride, or a combination thereof.

Upper conductive lines 260 may be disposed on the second interlayer insulating layer 240 in the cell region CR. The upper conductive lines 260 may be extended in the second direction D2 and may be spaced apart from each other in the first direction D1. The upper conductive lines 260 may be provided to cross the first and second cell conductive lines 192 and 196 and may be located at a height higher than the first and second cell conductive lines 192 and 196. Second conductive contacts 250 may be disposed on the cell via contacts 200, respectively, and may be spaced apart from each other in the first direction D1. The second conductive contacts 250 may be connected to the upper conductive lines 260, respectively. Each of the upper conductive lines 260 may be electrically connected to a corresponding one of the cell via contacts 200 through a corresponding one of the second conductive contacts 250. Each of the upper conductive lines 260 may serve as the word line WL of FIG. 1. The upper conductive lines 260 and the second conductive contacts 250 may include a conductive material and may be formed of or include, for example, a metallic material (e.g., copper).

In some implementations, the cell via contacts 200 between the first cell conductive lines 192 may be spaced apart from each other in the first direction D1 and may be extended in the second direction D2. Each of the cell via contacts 200 between the first cell conductive lines 192 may be a bar-shaped pattern, which is extended in the second direction D2, when viewed in a plan view as shown in Fig. 2, and may be connected to the dummy data storage patterns DS_d, which are spaced apart from each other in the second direction D2. Each of the cell via contacts 200 may include the vertical portion 200V, which is placed between the dummy data storage patterns DS_d and is extended in the third direction D3, and the horizontal portion 200H, which is extended from the vertical portion 200V in the second direction D2 and is connected to the dummy data storage patterns DS_d. The widths W1 and W2 of the horizontal portion 200H in the second direction D2 may increase as a distance from the vertical portion 200V in the third direction D3 increases. Since each of the cell via contacts 200 includes the horizontal portion 200H, the cell via contacts 200 may be easily formed. For example, during the formation of the cell via contacts 200, it may be possible to prevent or suppress a void from forming in the cell via contacts 200 and to prevent or suppress a bridge issue from occurring between the cell via contacts 200 and between the cell via contacts 200 and the first cell conductive lines 192.

In addition, the cell via contacts 200 may electrically connect the upper conductive lines 260 to the interconnection lines 102 in the interconnection structure 102 and/or 104. The upper conductive lines 260 may have a linewidth (or thickness or size) that is larger than the interconnection lines 102 in the interconnection structure 102 and/or 104, and thus, the upper conductive lines 260 may have a relatively small electric resistance. Each of the upper conductive lines 260 may serve as the word line WL of FIG. 1, and thus, an electric resistance of the word line WL constituting the memory cell MC of FIG. 1 may be lowered.

Thus, a risk of failure caused by a fabrication process may be reduced, which facilitates making a semiconductor device with improved electrical characteristics.

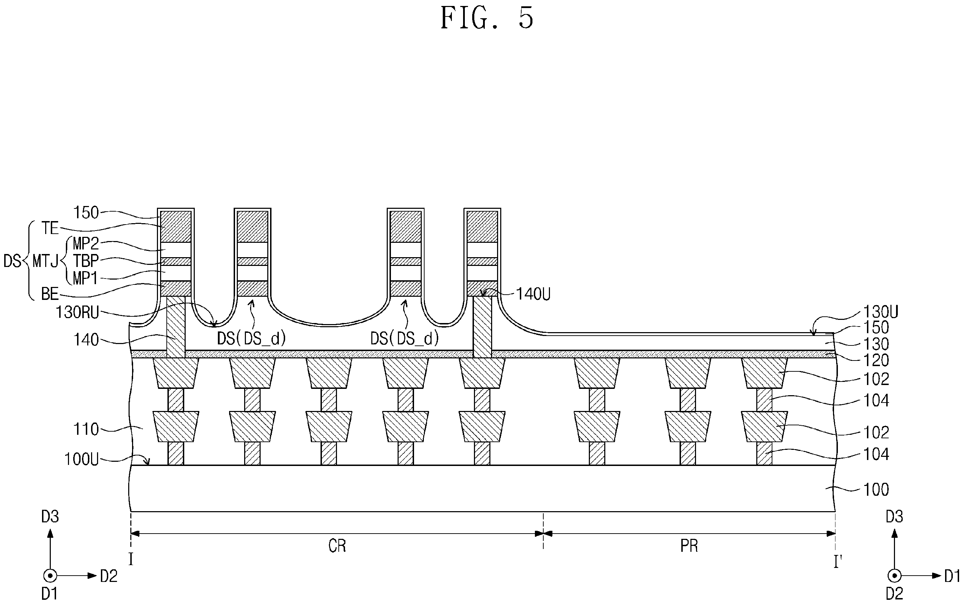

FIGS. 5 to 8 are sectional views along the line I-I' of FIG. 2 and illustrate a method of fabricating a semiconductor device. For concise description, an element previously described with reference to FIGS. 1 to 3, 4A, and 4B may be identified by the same reference number without repeating an overlapping description thereof.

Referring to FIGS. 2 and 5, a substrate 100 including a cell region CR and a peripheral region PR may be provided. The selection elements SE of FIG. 1 and peripheral transistors may be formed on the substrate 100, and an interconnection structure 102 and/or 104 may be formed on the selection elements and the peripheral transistors. The interconnection structure 102 and/or 104 may include interconnection lines 102, which are spaced apart from the substrate 100 vertically (e.g., in the third direction D3), and interconnection contacts 104, which are connected to the interconnection lines 102. Each of the interconnection lines 102 may be electrically connected to one terminal (e.g., a source, drain, or gate terminal) of a corresponding one of the selection elements or the peripheral transistors through a corresponding one of the interconnection contacts 104.

An interconnection insulating layer 110 may be formed on the substrate 100 to cover the interconnection structure 102 and/or 104. The interconnection insulating layer 110 may be formed to expose top surfaces of the uppermost ones of the interconnection lines 102.

A first lower insulating layer 120 may be formed on the interconnection insulating layer 110 to cover the exposed top surfaces of the uppermost interconnection lines 102. The first lower insulating layer 120 may be formed on the interconnection insulating layer 110 in the cell region CR and may be extended to cover the interconnection insulating layer 110 in the peripheral region PR.

A second lower insulating layer 130 may be formed on the first lower insulating layer 120. The second lower insulating layer 130 may be formed on the first lower insulating layer 120 in the cell region CR and may be extended to cover the first lower insulating layer 120 in the peripheral region PR.

Bottom electrode contacts 140 may be formed in the second lower insulating layer 130 and on the cell region CR. Each of the bottom electrode contacts 140 may be formed to penetrate the first and second lower insulating layers 120 and 130 in the cell region CR and may be electrically connected to the uppermost one of the interconnection lines 102. In some implementations, the formation of the bottom electrode contacts 140 may include forming lower contact holes to penetrate the first and second lower insulating layers 120 and 130 in the cell region CR, forming a lower contact layer to fill the lower contact holes on the second lower insulating layer 130, and planarizing the lower contact layer to expose a top surface of the second lower insulating layer 130. As a result of the planarization process, the bottom electrode contacts 140 may be locally formed in the lower contact holes, respectively.

Data storage patterns DS may be formed on the second lower insulating layer 130 in the cell region CR. The bottom electrode contacts 140 may be disposed below and electrically connected to respective ones of the data storage patterns DS. The data storage patterns DS may include dummy data storage patterns DS_d, which are disconnected from the bottom electrode contacts 140. For example, the magnetic tunnel junction (MTJ) pattern can be a dummy magnetic tunnel junction (MTJ) pattern.

Each of the data storage patterns DS may include a bottom electrode BE, a magnetic tunnel junction pattern MTJ, and a top electrode TE, which are sequentially stacked on the second lower insulating layer 130. The magnetic tunnel junction pattern MTJ may include a first magnetic pattern MP1, a second magnetic pattern MP2, and a tunnel barrier pattern TBP therebetween. The first magnetic pattern MP1 may be disposed between the bottom electrode BE and the tunnel barrier pattern TBP, and the second magnetic pattern MP2 may be disposed between the top electrode TE and the tunnel barrier pattern TBP. In some implementations, the formation of the data storage patterns DS may include sequentially forming a bottom electrode layer and a magnetic tunnel junction layer on the second lower insulating layer 130, forming a conductive mask pattern on the magnetic tunnel junction layer, and sequentially etching the magnetic tunnel junction layer and the bottom electrode layer using the conductive mask pattern as an etch mask. The magnetic tunnel junction layer may include a first magnetic layer, a tunnel barrier layer, and a second magnetic layer, which are sequentially stacked on the bottom electrode layer. In some implementations, the magnetic tunnel junction layer and the bottom electrode layer may be formed by a sputtering, chemical vapor deposition, or atomic layer deposition process.

As a result of the etching of the magnetic tunnel junction layer and the bottom electrode layer, the magnetic tunnel junction pattern MTJ and the bottom electrode BE may be formed, respectively. The etching of the magnetic tunnel junction layer may include sequentially etching the second magnetic layer, the tunnel barrier layer, and the first magnetic layer using the conductive mask pattern as an etch mask. The second magnetic layer, the tunnel barrier layer, and the first magnetic layer may be etched to form the second magnetic pattern MP2, the tunnel barrier pattern TBP, and the first magnetic pattern MP1, respectively. A portion of the conductive mask pattern, which is left on the magnetic tunnel junction pattern MTJ after the etching of the magnetic tunnel junction layer and the bottom electrode layer, may be referred to as the top electrode TE.

In some implementations, the process of etching the magnetic tunnel junction layer and the bottom electrode layer may be an ion beam etching process performed using an ion beam. The ion beam may include inert ions. As a result of the etching process, an upper portion of the second lower insulating layer 130 between the data storage patterns DS may be recessed. Accordingly, the second lower insulating layer 130 in the cell region CR may have a top surface 130RU that is recessed toward the substrate 100. The recessed top surface 130RU of the second lower insulating layer 130 may be located at a height lower than the top surfaces 140U of the bottom electrode contacts 140. In addition, an upper portion of the second lower insulating layer 130 in the peripheral region PR may also be recessed by the etching process. A top surface 130U of the second lower insulating layer 130 in the peripheral region PR may be located at a height lower than the recessed top surface 130RU of the second lower insulating layer 130 in the cell region CR.

A capping insulating layer 150 may be formed on the second lower insulating layer 130 in the cell region CR to conformally cover top and side surfaces of each of the data storage patterns DS. The capping insulating layer 150 may conformally cover the recessed top surface 130RU of the second lower insulating layer 130 in the cell region CR and may be extended to cover the top surface 130U of the second lower insulating layer 130 in the peripheral region PR.

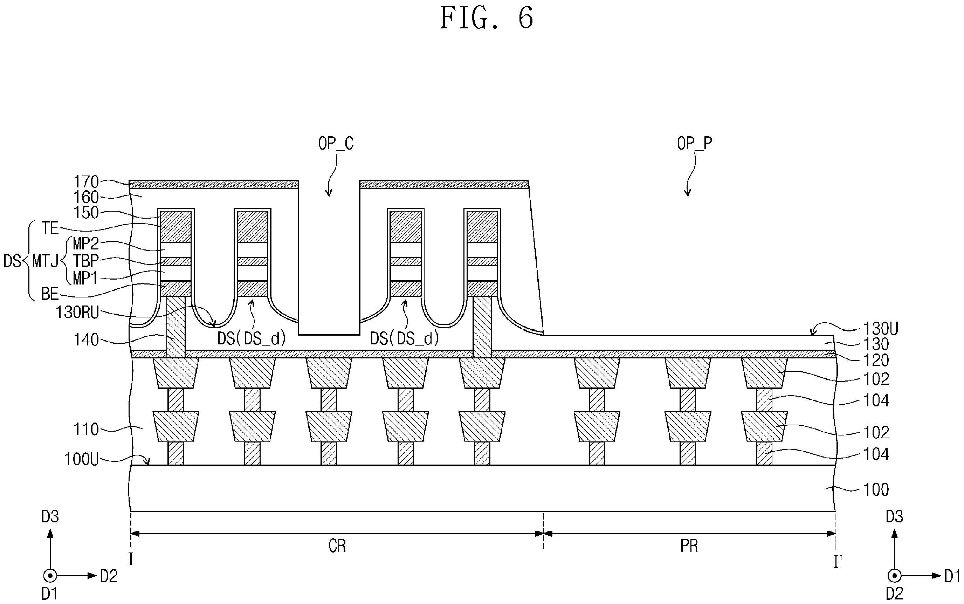

Referring to FIGS. 2 and 6, a cell insulating layer 160 may be formed on the capping insulating layer 150. The cell insulating layer 160 may be formed on the capping insulating layer 150 in the cell region CR to cover the data storage patterns DS and fill a space between the data storage patterns DS. The cell insulating layer 160 may be extended to cover the capping insulating layer 150 in the peripheral region PR. In some implementations, the cellinsulating layer 160 may be formed using a high density plasma chemical vapor deposition (HDP CVD) process.

An upper insulating layer 170 may be formed on the cell insulating layer 160. The upper insulating layer 170 may be formed on the cell insulating layer 160 in the cell region CR and may be extended to cover the cell insulating layer 160 in the peripheral region PR.

A peripheral opening OP_P may be formed in the peripheral region PR to expose the top surface 130U of the second lower insulating layer 130 in the peripheral region PR. The formation of the peripheral opening OP_P may include removing the upper insulating layer 170, the cell insulating layer 160, and the capping insulating layer 150 from the peripheral region PR. In some implementations, the formation of the peripheral opening OP_P may include forming a cell mask pattern on the upper insulating layer 170 in the cell region CR and etching the upper insulating layer 170, the cell insulating layer 160, and the capping insulating layer 150 in the peripheral region PR using the cell mask pattern as an etch mask. In some implementations, the cell mask pattern may be a photoresist pattern. Since the upper insulating layer 170, the cell insulating layer 160, and the capping insulating layer 150 are removed from the peripheral region PR, the top surface 130U of the second lower insulating layer 130 in the peripheral region PR may be exposed to the outside.

In some implementations, a cell opening OP_C may be formed on the cell region CR to expose the second lower insulating layer 130 between the dummy data storage patterns DS_d, which are spaced apart from each other in the second direction D2. Between the dummy data storage patterns DS_d, the cell opening OP_C may be formed to penetrate the upper insulating layer 170, the cell insulating layer 160, and the capping insulating layer 150 and may be extended into the second lower insulating layer 130. In some implementations, the formation of the cell opening OP_C may include forming the cell mask pattern on the upper insulating layer 170 in the cell region CR and etching the upper insulating layer 170, the cell insulating layer 160, the capping insulating layer 150, and a portion of the second lower insulating layer 130 between the dummy data storage patterns DS_d using the cell mask pattern as an etch mask. In some implementations, the cell mask pattern may include an opening that defines a region where the cell opening OP_C will be formed.

Thereafter, the cell mask pattern may be removed. In some implementations, the cell mask pattern may be removed by an ashing and/or strip process.

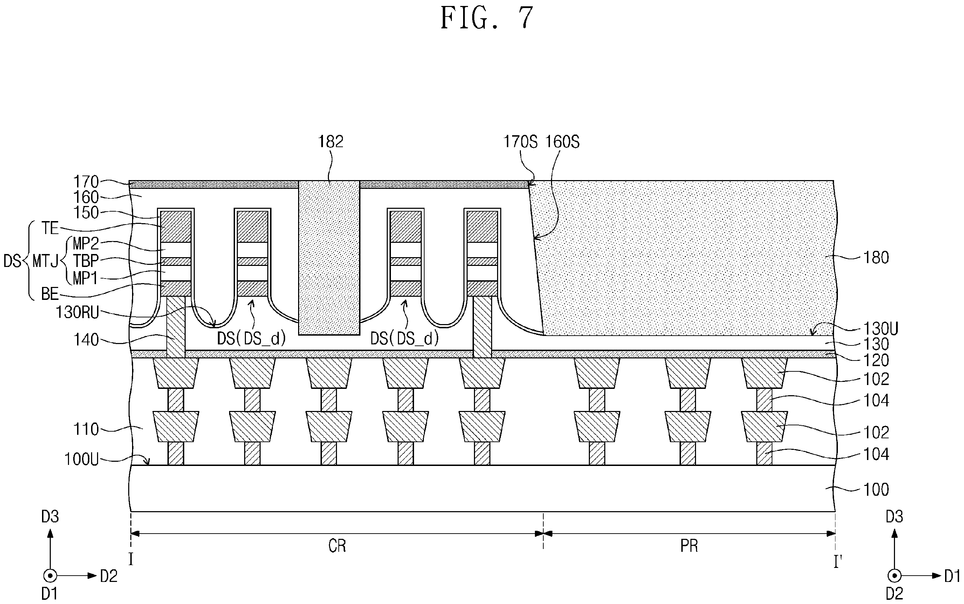

Referring to FIGS. 2 and 7, a peripheral insulating layer 180 may be formed to fill the peripheral opening OP_P. The peripheral insulating layer 180 may be in contact with the top surface 130U of the second lower insulating layer 130 in the peripheral region PR. The peripheral insulating layer 180 may be in contact with a side surface 160S of the cell insulating layer 160 in the cell region CR and may be in contact with a side surface 170S of the upper insulating layer 170 in the cell region CR.

In some implementations, a cell insulating pattern 182 may be formed to fill the cell opening OP_C. The cell insulating pattern 182 may be interposed between the dummy data storage patterns DS_d.

The peripheral insulating layer 180 and the cell insulating pattern 182 may include an insulating material having a dielectric constant lower than the cell insulating layer 160 and the upper insulating layer 170. The peripheral insulating layer 180 and the cell insulating pattern 182 may include the same material. In some implementations, the formation of the peripheral insulating layer 180 and the cell insulating pattern 182 may include forming an insulating layer to fill the peripheral opening OP_P and the cell opening OP_C and planarizing the insulating layer to expose a top surface of the upper insulating layer 170. In some implementations, the insulating layer may be formed using a chemical vapor deposition process. The planarization process may be performed using at least one of an etch-back process and a chemical mechanical polishing process.

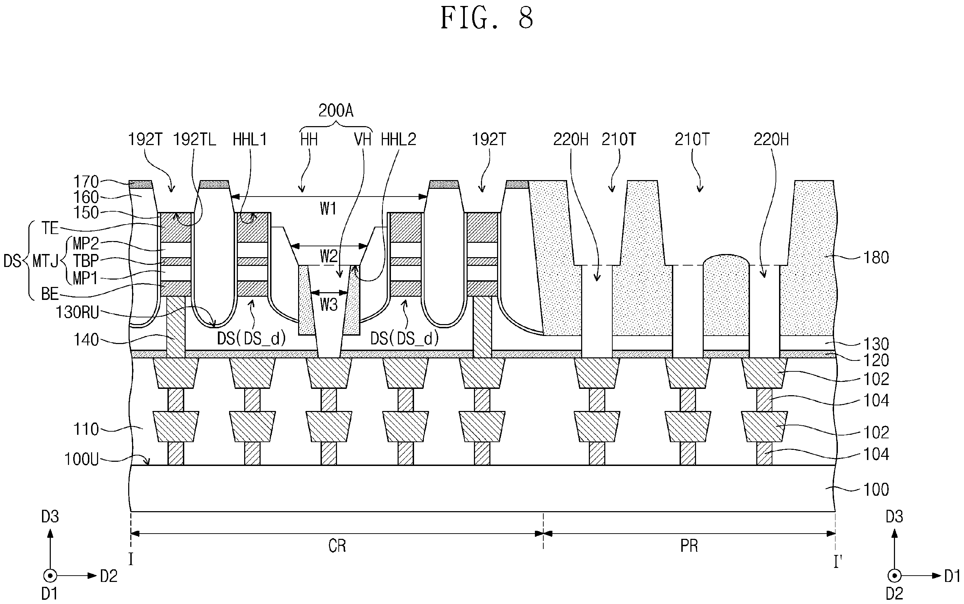

Referring to FIGS. 2 and 8, first cell trenches 192T may be formed on the cell region CR. The first cell trenches 192T may be extended in the first direction D1 and may be spaced apart from each other in the second direction D2. Each of the first cell trenches 192T may be a line-shaped region, which is extended in the first direction D1, and may be formed to expose corresponding ones of the data storage patterns DS, which are spaced apart from each other in the first direction D1. Each of the first cell trenches 192T may be formed to penetrate the upper insulating layer 170 and an upper portion of the cell insulating layer 160. A bottom surface 192TL of each of the first cell trenches 192T may expose the top electrode TE of a corresponding one of the data storage patterns DS.

Cell via holes 200A may be formed on the cell region CR and between the first cell trenches 192T. The cell via holes 200A between the first cell trenches 192T may be spaced apart from each other in the first direction D1 and may be extended in the second direction D2. Each of the cell via holes 200A may be a bar-shaped region, which is extended in the second direction D2 when viewed in a plan view. The cell via holes 200A may be spaced apart from the first cell trenches 192T in a horizontal direction (e.g., the second direction D2).

Each of the cell via holes 200A may expose the dummy data storage patterns DS_d, which are spaced apart from each other in the second direction D2. Each of the cell via holes 200A may include a horizontal hole HH, which is extended in the second direction D2 to expose the dummy data storage patterns DS_d, and a vertical hole VH, which is extended from a bottom surface of the horizontal hole HH into a region between the dummy data storage patterns DS_d in the third direction D3. The vertical hole VH may be spaced apart from the dummy data storage patterns DS_d in a horizontal direction (e.g., the second direction D2).

Each of the cell via holes 200A may have a width in the second direction D2. Widths W1 and W2 of the horizontal hole HH in the second direction D2 may increase as a distance from the vertical hole VH in the third direction D3 increases. In some implementations, a width W1 of an upper portion of the horizontal hole HH may be larger than a width W2 of a lower portion of the horizontal hole HH. The width W2 of the lower portion of the horizontal hole HH may be larger than the largest width W3 of the vertical hole VH.

In some implementations, the horizontal hole HH may be formed to penetrate the upper insulating layer 170, an upper portion of the cell insulating layer 160, and an upper portion of the cell insulating pattern 182. A bottom surface HHL1 of the horizontal hole HH may be formed to expose the dummy data storage patterns DS_d. For example, the bottom surface HHL1 of the horizontal hole HH may be formed to expose the top electrode TE of each of the dummy data storage patterns DS_d. The vertical hole VH may be extended from the lowermost bottom surface HHL2 of the horizontal hole HH toward the substrate 100 in the third direction D3. The lowermost bottom surface HHL2 of the horizontal hole HH may be located at a height that is lower than the bottom surface HHL1 of the horizontal hole HH and is lower than the bottom surfaces 192TL of the first cell trenches 192T. In some implementations, the vertical hole VH may be disposed in the cell insulating pattern 182. The vertical hole VH may be formed to penetrate the cell insulating pattern 182, the second lower insulating layer 130, and the first lower insulating layer 120 and expose a top surface of a corresponding one of the uppermost interconnection lines 102.

Peripheral trenches 210T may be formed in the peripheral insulating layer 180 in the peripheral region PR. Each of the peripheral trenches 210T may be formed to penetrate an upper portion of the peripheral insulating layer 180 in the peripheral region PR. Peripheral holes 220H may be extended from bottom surfaces of the peripheral trenches 210T toward the substrate 100 in the third direction D3. Each of the peripheral holes 220H may penetrate a lower portion of the peripheral insulating layer 180 in the peripheral region PR and may also penetrate the second lower insulating layer 130 and the first lower insulating layer 120 in the peripheral region PR, thereby exposing a top surface of a corresponding one of the uppermost interconnection lines 102.

The first cell trenches 192T, the horizontal holes HH of the cell via holes 200A, and the peripheral trenches 210T may be formed by a first etching process. As an example, the first etching process may include forming a first mask pattern to define positions and sizes of the first cell trenches 192T, the horizontal holes HH of the cell via holes 200A, and the peripheral trenches 210T and etching the upper insulating layer 170, the cell insulating layer 160, the cell insulating pattern 182, and the peripheral insulating layer 180 using the first mask pattern as an etch mask. The first cell trenches 192T, the horizontal holes HH of the cell via holes 200A, and the peripheral trenches 210T may be formed at the same time by the first etching process.

The vertical holes VH of the cell via holes 200A and the peripheral holes 220H may be formed by a second etching process. As an example, the second etching process may include forming a second mask pattern to define positions and sizes of the vertical holes VH and the peripheral holes 220H and etching the cell insulating pattern 182, the peripheral insulating layer 180, the second lower insulating layer 130, and the first lower insulating layer 120 using the second mask pattern as an etch mask. The vertical holes VH of the cell via holes 200A and the peripheral holes 220H may be formed at the same time by the second etching process.

Referring back to FIGS. 2 and 3, first cell conductive lines 192 may be formed in the cell trenches 192T, respectively, and cell via contacts 200 may be formed in the cell via holes 200A, respectively. Peripheral conductive lines 210 may be formed in the peripheral trenches 210T, respectively, and peripheral conductive contacts 220 may be formed in the peripheral holes 220H, respectively. The cell via contacts 200 may include a vertical portion 200V filling the vertical hole VH and a horizontal portion 200H filling the horizontal hole HH.

In some implementations, the formation of the first cell conductive lines 192, the cell via contacts 200, the peripheral conductive lines 210, and the peripheral conductive contacts 220 may include forming a first conductive layer on the upper insulating layer 170 and the peripheral insulating layer 180 to fill the cell trenches 192T, the cell via holes 200A, the peripheral trenches 210T, and the peripheral holes 220H and planarizing the first conductive layer to expose a top surface 170U of the upper insulating layer 170 and a top surface 180U of the peripheral insulating layer 180. As a result of the planarization process, top surfaces 192U of the first cell conductive lines 192, the top surface 170U of the upper insulating layer 170, top surfaces 200HU of the cell via contacts 200, the top surface 180U of the peripheral insulating layer 180, and top surfaces 210U of the peripheral conductive lines 210 may be located at the same height.

A first interlayer insulating layer 230 may be formed on the cell region CR and the peripheral region PR and may cover the top surface 170U of the upper insulating layer 170, the top surfaces 192U of the first cell conductive lines 192, the top surfaces 200HU of the cell via contacts 200, the top surface 180U of the peripheral insulating layer 180, and the top surfaces 210U of the peripheral conductive lines 210.

Second cell conductive lines 196 and first conductive contacts 194 may be formed in the first interlayer insulating layer 230. In some implementations, the formation of the second cell conductive lines 196 and the first conductive contacts 194 may include forming second cell trenches to penetrate an upper portion of the first interlayer insulating layer 230, forming first holes, which are extended from a bottom surface of each of the second cell trenches to penetrate a lower portion of the first interlayer insulating layer 230, forming a second conductive layer on the first interlayer insulating layer 230 to fill the second cell trenches and the first holes, and planarizing the second conductive layer to expose a top surface of the first interlayer insulating layer 230.

A second interlayer insulating layer 240 may be formed on the cell region CR and the peripheral region PR and may cover top surfaces of the second cell conductive lines 196. Upper conductive lines 260 may be formed on the second interlayer insulating layer 240 in the cell region CR, and second conductive contacts 250 may be formed in the second interlayer insulating layer 240. The second conductive contacts 250 may penetrate the first and second interlayer insulating layers 230 and 240 and may be connected to the cell via contacts 200, respectively. In some implementations, the upper conductive lines 260 and the second conductive contacts 250 may be formed using substantially the same method as that for the second cell conductive lines 196 and the first conductive contacts 194.

In some implementations, the widths W1 and W2 of the horizontal hole HH of each of the cell via holes 200A in the second direction D2 may increase as a distance from the vertical hole VH in the third direction D3 increases. Accordingly, the first conductive layer may be formed to easily fill the cell via holes 200A, and as a result, it may be possible to prevent or suppress a void from being formed in the cell via contacts 200. In addition, each of the cell via contacts 200 may be a bar-shaped pattern, which is elongated in the second direction when viewed in a plan view, and thus, it may be possible to prevent or suppress a bridge issue from being formed between the cell via contacts 200, which are spaced apart from each other in the first direction D1. The horizontal portion 200H of the cell via contacts 200 may be spaced apart from the first cell conductive lines 192 in a horizontal direction (e.g., the second direction D2). Accordingly, it may be possible to minimize the bridge issue, which occurs between the cell via contacts 200 and the first cell conductive lines 192.

In addition, the cell via contacts 200 may electrically connect the upper conductive lines 260, which are used as the word lines WL of FIG. 1, to the interconnection lines 102 in the interconnection structure 102 and/or 104. The upper conductive lines 260 may have an electric resistance that is lower than that of the interconnection lines 102 in the interconnection structure 102 and/or 104, and thus, the electric resistance of the word line WL constituting the memory cell MC of FIG. 1 may be lowered.

Thus, a failure caused by a fabrication process may be minimized, and this may make it possible to realize a semiconductor device with improved electrical characteristics and a fabrication process with improved reliability.

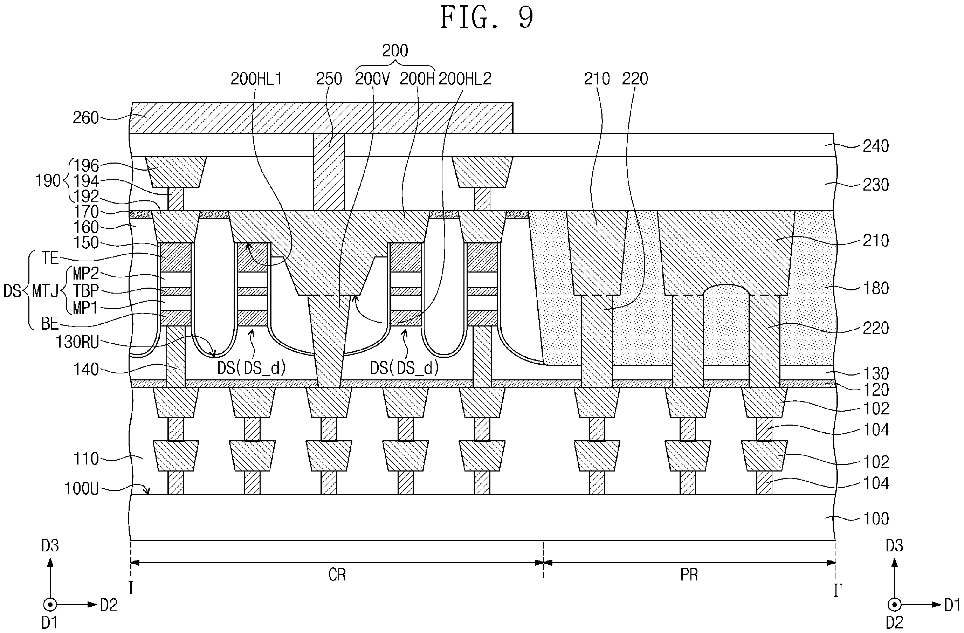

FIG. 9 is a sectional view, which is taken along the line I-I' of FIG. 2 to illustrate a semiconductor device. For concise description, an element previously described with reference to FIGS. 2, 3, 4A, and 4B may be identified by the same reference number without repeating an overlapping description thereof.

Referring to FIGS. 2 and 9, the cell insulating pattern 182 described with reference to FIG. 3 may be omitted from the semiconductor device of FIG. 9. In this case, each of the cell via contacts 200 may be provided to penetrate the upper insulating layer 170, the cell insulating layer 160, the capping insulating layer 150, the second lower insulating layer 130, and the first lower insulating layer 120. The horizontal portion 200H of each of the cell via contacts 200 may penetrate the upper insulating layer 170 and an upper portion of the cell insulating layer 160, and the bottom surface 200HL1 of the horizontal portion 200H may be in contact with the dummy data storage patterns DS_d. The vertical portion 200V of each of the cell via contacts 200 may be extended from the bottommost surface 200HL2 of the horizontal portion 200H toward the substrate 100. The vertical portion 200V may penetrate a lower portion of the cell insulating layer 160, the capping insulating layer 150, the second lower insulating layer 130, and the first lower insulating layer 120 and may be connected to a corresponding one of the uppermost interconnection lines 102. Except for the afore-described difference, the semiconductor device of FIG. 9 may be substantially the same as the semiconductor device described with reference to FIGS. 2, 3, 4A, and 4B.

In some implementations, each of cell via holes may include a horizontal hole and a vertical hole, which is extended from the bottommost surface of the horizontal hole toward a substrate, and a width of an upper portion of the horizontal hole may be larger than a width of a lower portion of the horizontal hole. Thus, the cell via holes may be easily filled with a first conductive layer, and as a result, it may be possible to prevent or suppress a void from being formed in cell via contacts. Here, when viewed in a plan view, each of the cell via contacts may be a bar-shaped pattern elongated in a second direction, and in this case, it may be possible to minimize a bridge issue between the cell via contacts, which are spaced apart from each other in a first direction. A horizontal portion of the cell via contact may be spaced apart from a first cell conductive line in a horizontal direction (e.g., the second direction), and this may make it possible to minimize a bridge issue between the cell via contacts and the first cell conductive lines.

In addition, upper conductive lines having a relatively small electric resistance may be connected to selection elements, which are provided on the substrate, through the cell via contacts and may be used as word lines. Accordingly, an electric resistance of the word lines constituting a memory cell may be lowered.

Thus, a failure caused by a fabrication process may be minimized, and this may make it possible to realize a semiconductor device with improved electrical characteristics and a fabrication process with improved reliability.

While example embodiments of the inventive concept have been particularly shown and described, it will be understood by one of ordinary skill in the art that variations in form and detail may be made therein without departing from the scope of the attached claims.

## Claims

1. A semiconductor device, comprising:
data storage patterns provided on a substrate and spaced apart from each other in a first direction and a second direction, the first and second directions being non-parallel to each other and parallel to a top surface of the substrate;
first cell conductive lines provided on the data storage patterns, extending in the first direction, and spaced apart from each other in the second direction, each of the first cell conductive lines being connected to corresponding ones of the data storage patterns that are spaced apart from each other in the first direction; and
cell via contacts spaced apart from each other in the first direction between the first cell conductive lines,
wherein each of the cell via contacts between the first cell conductive lines extends in the second direction and is connected to dummy data storage patterns of the data storage patterns that are spaced apart from each other in the second direction.

2. The semiconductor device of claim 1, wherein each of the cell via contacts comprises:
a vertical portion provided between the dummy data storage patterns and extending in a third direction perpendicular to the top surface of the substrate; and
a horizontal portion provided on the vertical portion, extending in the second direction, and connected to the dummy data storage patterns.

3. The semiconductor device of claim 2, wherein the vertical portion is horizontally spaced apart from the dummy data storage patterns,
the horizontal portion comprises end portions that are opposite to each other in the second direction, and
the dummy data storage patterns are connected to corresponding end portions of the end portions of the horizontal portion.

4. The semiconductor device of claim 3, wherein the horizontal portion is horizontally spaced apart from the first cell conductive lines.

5. The semiconductor device of any of claims 2 to 4, wherein a width of the horizontal portion in the second direction increases as a distance from the vertical portion in the third direction increases.

6. The semiconductor device of any of claims 2 to 5, wherein a bottom surface of each of the first cell conductive lines contacts the corresponding ones of the data storage patterns, and
wherein a bottom surface of the horizontal portion of each of the cell via contacts contacts the dummy data storage patterns.

7. The semiconductor device of claim 6, wherein the vertical portion is connected to a bottommost surface of the horizontal portion, and
wherein the bottommost surface of the horizontal portion is located at a height lower than the bottom surface of each of the first cell conductive lines.

8. The semiconductor device of any of claims 2 to 7, wherein a top surface of the horizontal portion of each of the cell via contacts is located at a same height as top surfaces of the first cell conductive lines.

9. The semiconductor device of any of claims 2 to 8, further comprising:
an interconnection structure between the substrate and the data storage patterns; and
bottom electrode contacts between the interconnection structure and the data storage patterns,
wherein the bottom electrode contacts are respectively connected to the corresponding ones of the data storage patterns,
wherein each of the bottom electrode contacts is connected to a corresponding uppermost conductive line of the interconnection structure, and
wherein the vertical portion of each of the cell via contacts is connected to the corresponding uppermost conductive line of the interconnection structure.

10. The semiconductor device of any preceding claim, further comprising:
second cell conductive lines provided on the first cell conductive lines, extending in the first direction, and spaced apart from each other in the second direction; and
first conductive contacts provided between the first cell conductive lines and the second cell conductive lines,
wherein each of the second cell conductive lines is electrically connected to a corresponding one of the first cell conductive lines through corresponding ones of the first conductive contacts.

11. The semiconductor device of claim 10, further comprising:
second conductive contacts disposed on the cell via contacts, respectively; and
upper conductive lines disposed on the second conductive contacts,
wherein each of the upper conductive lines is electrically connected to a corresponding one of the cell via contacts through a corresponding one of the second conductive contacts, and
wherein the upper conductive lines are located at a height from the substrate that is higher than the second cell conductive lines.
